# DEMANDE DE BREVET EUROPEEN

(11) **EP 2 610 907 A1**
(43) Date de publication de la demande: **03.07.2013**
(21) Numéro de dépôt: 13161161.8
(22) Date de dépôt: 02.06.2009
(51) Int. Cl.: H01L 21/98, H01L 25/065, H01L 23/31, H01L 21/60

(54) **Dispositif electronique empile et procede de realisation d'un tel dispositif electronique**

(30) Priorité: 03.06.2008 FR 0853662
(62) Demande divisionnaire de: 09757529.4
(71) Demandeur: Commissariat à l'Énergie Atomique et aux Énergies Alternatives, 75015 Paris (FR)
(72) Inventeur: Brun, Jean, 38800 Champagnier (FR)
(74) Mandataire: Ilgart, Jean-Christophe

(57) **Abrégé**

Il s'agit d'un dispositif électronique empilé formé de composants électroniques (120, 130) empilés répartis sur un ou plusieurs niveaux rapportés (N2, N3) les uns sur les autres à partir d'un niveau de base (N1) accueillant éventuellement au moins un composant électronique (110). Au moins un plot de connexion électrolytique de premier type (10.1) d'un niveau rapporté (N2) relie directement un élément conducteur (c1) placé sur une face d'un composant électronique (120) d'un niveau rapporté (N2) à un élément conducteur (z1) placé sur une face en regard d'un niveau voisin (N1) tandis qu'au moins un plot de connexion électrolytique de second type (20.1) du niveau rapporté (N2) traverse de part en part une couche d'enrobage (220) enrobant latéralement le composant électronique (120) du niveau rapporté (N2) et relie électriquement directement deux éléments conducteurs (z1, z2) situés de part et d'autre de ladite couche d'enrobage (220).

## Description

### DOMAINE TECHNIQUE

La présente invention concerne un dispositif électronique empilé formé d'un empilement de composants électroniques devant être connectés électriquement entre eux. Par composant électronique, on entend tout élément nécessitant d'être relié électriquement à un autre élément et par exemple un circuit intégré, un composant passif ou actif discret, un MEMS, NEMS ou autre. Le composant électronique peut par exemple regrouper plusieurs sous éléments électroniques indépendants.

### ÉTAT DE LA TECHNIQUE ANTÉRIEURE

Actuellement dans les dispositifs électroniques empilés qui comportent plus de deux niveaux, on rapporte les composants électroniques les uns sur les autres et on les connecte par billes fusibles, par liaisons filaires, par métallisations. Dans le brevet US 5 311401 les différents composants sont reliés électriquement entre eux par des métallisations qui s'étendent sur les flancs de l'empilement. Ces dispositifs électroniques ont des densités d'intégration trop faibles. De plus, la présence des métallisations ou des billes fusibles limite la température maximale qui peut être utilisée ultérieurement à leur réalisation. En outre des problèmes de compatibilité entre matériaux peuvent se poser notamment si du plomb est employé. La solution présentée dans le brevet US 5 311401 est complexe, elle n'est pas collective, le dispositif électronique ne peut être fabriqué par lots et séparé ensuite de ses voisins.

Pour augmenter la densité d'intégration, il existe d'autres dispositifs électroniques comme ceux montrés dans le brevet US 5 104 820. Les composants électroniques sont empilés et solidarisés par collage de manière à former sensiblement des cubes. Les connexions entre deux composants se font par métallisation d'une ou plusieurs faces principales puis en gravant des lignes conductrices dans les métallisations. Ici encore le dispositif électronique ne peut être fabriqué de manière collective et son coût est élevé. Le procédé utilisé n'est rentable que pour des dispositifs électroniques à forte valeur ajoutée.

On connait également par la demande de brevet EP 1775 768, un dispositif électronique formé d'un substrat de base sur lequel sont empilés trois niveaux de composants électroniques. Seul le premier niveau de composant électronique est relié à des pistes conductrices munies de plots, portées par le substrat de base. Cette connexion se fait par des micro protubérances conductrices supportées d'un côté par les plots et de l'autre par le composant électronique. L'assemblage se fait par de la colle conductrice au niveau des protubérances et par de l'adhésif isolant ailleurs. Chaque autre niveau de composant électronique est assemblé de cette façon au niveau de composant qui le précède. Aucune possibilité n'est prévue pour connecter un niveau de composant éloigné du substrat, au substrat.

Dans les demandes de brevet américain US 2003/0017647 et US 2004/0178495 les composants électroniques placés sur un substrat sont empilés en étant séparés par une couche diélectrique, les interconnexions entre un niveau et un niveau voisin se faisant par des billes fusibles, et celles entre le substrat d'un niveau et le substrat d'un autre niveau se faisant d'un côté par des billes fusibles et de l'autre par des plots de cuivre au travers de traversées (vias) métallisées.

Un inconvénient des structures divulguées dans ces documents est qu'un grand nombre de métaux sont utilisés pour faire les connexions, ces métaux venant en contact direct deux à deux. Dans ces documents sont cités le cuivre, l'argent, le titane, le nickel. De la corrosion risque d'apparaître à l'interface entre ces différents métaux. Un autre inconvénient est la complexité des connexions des différents niveaux ce qui conduit à des dispositifs électroniques coûteux et à des rendements médiocres.

Encore un autre inconvénient est lié à l'utilisation des billes fusibles. Leur point de fusion étant inférieur à environ 300°C cela limite la température qui peut être atteinte lors d'étapes ultérieures à leur formation. De plus, elles conduisent à des dispositifs électroniques épais car les espacements entre niveaux dus aux billes fusibles est important, de l'ordre de 50 à 100 micromètres au minimum.

### EXPOSÉ DE L'INVENTION

La présente invention a justement comme but de proposer un dispositif électronique empilé à plus de deux niveaux à densité d'intégration accrue qui ne présente pas les inconvénients mentionnés ci-dessus notamment au niveau de la corrosion et du coût

Un autre but de l'invention est de proposer un dispositif électronique empilé qui soit relativement peu épais compte tenu du nombre de niveaux empilés.

Pour y parvenir, la présente invention est un procédé de réalisation d'un dispositif électronique empilé comportant des composants électroniques empilés répartis sur au moins un niveau rapporté les uns sur les autres à partir d'un niveau de base accueillant éventuellement au moins un composant électronique, tel que défini dans la revendication 1.

Au moins un plot de connexion électrolytique de premier type d'un niveau rapporté donné relie directement un élément conducteur placé sur une face d'un composant électronique du niveau rapporté à un élément conducteur placé sur une face en regard d'un niveau voisin sous-jacent. De plus, au moins un plot de connexion électrolytique de second type du niveau rapporté donné traverse de part en part une couche d'enrobage enrobant latéralement le composant électronique du niveau rapporté donné et relie électriquement directement deux éléments conducteurs situés de part et d'autre de ladite couche d'enrobage. En outre, le dispositif électronique empilé comporte des plots de connexion électrolytique de premier type d'un niveau rapporté directement sus-jacent au niveau rapporté donné, chacun est relié électriquement à un plot de connexion électrolytique de second type du niveau rapporté donné.

Plusieurs composants électroniques peuvent se trouver côte à côte sur un même niveau.

Il est préférable pour limiter l'épaisseur du dispositif électronique empilé, qu'un plot de connexion électrolytique de premier type ait une hauteur inférieure à celle d'un plot de connexion électrolytique de second type, ce dernier ayant sa hauteur conditionnée par l'épaisseur du composant électronique à côté duquel il se trouve.

Il est possible qu'un plot de connexion électrolytique de premier type soit un micro-insert ou un ensemble de micro-inserts en forme de picot.

En variante, un plot de connexion électrolytique de premier type peut être une bille fusible, si la température n'est pas trop une contrainte. La bille fusible peut être réalisée dans un matériau fusible à base d'indium, de plomb -étain, de plomb-argent-cuivre, d'argent-étain-cuivre.

Un plot de connexion électrolytique de premier type et/ou un plot de connexion électrolytique de second type peuvent être réalisés à base de cuivre et/ou de nickel et/ou d'or.

Un composant électronique d'un niveau rapporté peut être assemblé au niveau voisin sous-jacent par collage.

Une couche diélectrique peut revêtir la couche d'enrobage et le composant électronique enrobé latéralement par la couche d'enrobage du niveau rapporté donné et posséder au moins une ouverture au niveau d'un sommet d'un plot de connexion électrolytique de second type du niveau rapporté donné.

Au moins une piste conductrice peut s'étendre sur la couche diélectrique et l'ouverture, cette piste conductrice formant éventuellement l'élément conducteur placé sur une face en regard du niveau rapporté directement sus-jacent au niveau rapporté donné correspondant à l'un des deux éléments conducteurs situés de part et d'autre de ladite couche d'enrobage.

Pour faciliter la réalisation et réduire les coûts et l'épaisseur du dispositif électronique empilé, un plot de connexion électrolytique de premier type du niveau rapporté directement sus-jacent au niveau rapporté donné peut être situé directement dans le prolongement d'un plot de connexion électrolytique de second type du niveau rapporté donné.

En variante, un plot de connexion électrolytique de premier type du niveau rapporté directement sus-jacent au niveau rapporté donné peut être décalé par rapport à un plot de connexion électrolytique de second type du niveau rapporté donné.

L'élément conducteur placé sur une face en regard du niveau rapporté donné relié électriquement à un plot de connexion électrolytique de premier type du niveau rapporté directement sus-jacent au niveau rapporté donné est de préférence une piste conductrice également connectée au plot de connexion électrolytique de second type du niveau rapporté directement sus-jacent au niveau rapporté donné.

Il est possible que deux plots de connexion électrolytiques de même type de niveaux différents soient dans le prolongement l'un de l'autre.

Un procédé de réalisation d'un dispositif électronique empilé comportant des composants électroniques empilés répartis sur au moins un niveau sur un niveau de base accueillant éventuellement au moins un composant électronique, peut comporter les étapes dans lesquelles on :
a°) réalise par électrolyse sur le niveau de base au moins un plot de connexion électrolytique de premier type, le plot de connexion électrolytique de premier type étant en contact électrique direct avec un élément conducteur du niveau de base ;
b°) rapporte au moins un composant électronique du niveau rapporté dit premier niveau rapporté, sur le niveau de base et on l'assemble de manière à ce qu'un élément conducteur porté par une face du composant électronique soit en contact électrique direct avec le plot de connexion électrolytique de premier type réalisé à l'étape a°);
c°) réalise par électrolyse sur le niveau de base au moins un plot de connexion électrolytique de second type, le plot de connexion électrolytique de second type étant en contact électrique direct avec au moins un second élément conducteur du niveau de base, ce plot de connexion électrolytique de second type affleurant ou dépassant le composant électronique du premier niveau rapporté ;
d°) enrobe le plot de connexion électrolytique de second type réalisé à l'étape c°) et le composant électronique du premier niveau rapporté d'un matériau d'enrobage, le sommet du plot de connexion électrolytique de second type étant à nu, les étapes a°) à d°) ne contribuant à réaliser que le premier niveau rapporté ;
e°) réalise par électrolyse sur le premier niveau rapporté, des plots de connexion électrolytiques de premier type, chaque plot de connexion électrolytique de premier type étant en contact électrique avec un plot de connexion électrolytique de second type réalisé à l'étape c°).

Un plot de connexion de premier type réalisé sur le premier niveau rapporté peut être en contact électrique direct avec un premier élément conducteur du premier niveau rapporté.

Le procédé peut comporter en outre les étapes dans lesquelles on:
f°) rapporte au moins un composant électronique du second niveau rapporté sur le premier niveau rapporté et on l'assemble de manière à ce qu'un élément conducteur porté par une face du composant électronique soit en contact électrique direct avec le plot de connexion électrolytique de premier type réalisé à l'étape e°);
g°) réalise par électrolyse sur le premier niveau rapporté au moins un plot de connexion électrolytique de second type, le plot de connexion électrolytique de second type étant en contact électrique direct avec un second élément conducteur du premier niveau rapporté, ce plot de connexion électrolytique de second type affleurant ou dépassant le composant électronique du second niveau rapporté ;
h°) enrobe le plot de connexion électrolytique de second type réalisé à l'étape g°) et le composant électronique du second niveau rapporté d'un matériau d'enrobage, le sommet du plot de connexion électrolytique de second type étant à nu, ces étapes contribuant à réaliser le second niveau rapporté.

Si l'on désire que le dispositif électronique empilé ait plus de deux niveaux rapportés, on peut réitérer les étapes e°) à h°) au moins une nième fois (n supérieur ou égal à deux) de manière à obtenir n+1 niveaux rapportés, le premier niveau rapporté devenant le nième-1 niveau rapporté, le second niveau rapporté devenant le nième niveau rapporté, le niveau de base devenant le nième-2 niveau.

Le plot de connexion électrolytique de second type peut être situé hors de l'emprise que le composant électronique du niveau rapporté possède sur le niveau sous-jacent.

Aux étapes d°) ou h°) la mise à nu du sommet du plot de connexion électrolytique de second type peut être obtenue par rodage au moins du matériau d'enrobage et éventuellement du composant électronique du premier niveau rapporté et/ou du second niveau rapporté.

On peut réaliser le premier élément conducteur et/ou le second élément conducteur du niveau de base en gravant un fond conducteur formé en surface du niveau de base.

Similairement, on peut réaliser le premier élément conducteur et/ou le second élément conducteur du premier niveau rapporté en gravant un fond conducteur formé en surface du premier niveau rapporté, ce fond conducteur surmontant une couche diélectrique ouverte au niveau du sommet du plot de connexion électrolytique de second type réalisé à l'étape g°).

Dans certaines configurations, le premier élément conducteur et le second élément conducteur du niveau de base peuvent être confondus et/ou le premier élément conducteur et le second élément conducteur du premier niveau rapporté peuvent être confondus.

On peut faire croître par électrolyse le plot de connexion électrolytique de premier type réalisé à l'étape e°) directement sur le sommet du plot de connexion électrolytique de second type réalisé à l'étape c°).

On peut procéder à une étape de refusion entre l'étape e°) et l'étape f°) pour que le plot de connexion de premier type réalisé à l'étape e°) se transforme en bille fusible, si bien sûr ledit plot de connexion de premier type est réalisé dans un matériau approprié.

Dans certaines configurations, notamment si le composant électronique à rapporter est peu épais, il est possible que l'étape b°) soit réalisée après l'étape c°) et/ou l'étape f°) soit réalisée après l'étape g°).

Dans une configuration où le composant électronique est épais, lorsque l'étape b°) est réalisée avant l'étape c°) et/ou l'étape f°) est réalisée avant l'étape g°), on peut amincir le composant électronique avant l'étape c°) et/ou l'étape f°).

Lorsque le dispositif électronique empilé comporte plusieurs dispositifs électroniques empilés élémentaires, à l'issue de la réalisation du dernier niveau rapporté, on peut effectuer une découpe totale ou partielle du dispositif électronique empilé pour séparer les dispositifs électroniques empilés élémentaires les uns des autres. La découpe peut être une découpe d'au moins un élément conducteur visant à séparer électriquement les dispositifs électroniques empilés élémentaires.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A à 1K illustrent des étapes de réalisation du premier niveau rapporté du dispositif électronique empilé obtenu dans le procédé de l'invention ;
- les figures 2A, 2B illustrent des étapes optionnelles permettant de finir le premier niveau rapporté du dispositif électronique empilé obtenu par le procédé de l'invention ;
- les figures 3A à 3E illustrent des étapes de réalisation du second niveau rapporté du dispositif électronique empilé par le procédé de l'invention ;
- les figures 4A, 4B illustrent des étapes optionnelles permettant de finir le second niveau rapporté du dispositif électronique empilé obtenu par le procédé de l'invention ;
- les figures 5A à 5D illustrent des étapes de réalisation du troisième niveau rapporté du dispositif électronique empilé obtenu par le procédé de l'invention ;
- les figures 6A, 6B illustrent des étapes permettant d'obtenir par découpe des dispositifs électroniques empilés élémentaires obtenus par le procédé de l'invention ;
- les figures 7A à 7C illustrent une configuration dans laquelle un composant électronique d'un niveau rapporté est particulièrement épais ;
- les figures 8A à 8C illustrent une configuration dans laquelle un composant électronique d'un niveau rapporté est particulièrement mince ;
- les figures 9A1, 9A2, 9B1, 9B2, 9C et 9D illustrent des configurations dans lesquelles des plots de connexion électrolytiques de premier type d'un niveau donné sont réalisés directement sur des plots de connexion électrolytiques de second type du niveau voisin sous-jacent ;
- les figures 10A à 10D illustrent une configuration dans laquelle les plots de connexion électrolytiques de premier type sont des billes fusibles ;
- les figures 11A à 11C illustrent une configuration dans laquelle des plots de connexion électrolytiques de premier type d'un niveau rapporté sont connectés électriquement à des plots de connexion électrolytiques de second type du niveau voisin sous-jacent en étant décalés par rapport à ces derniers ;
- la figure 12 montre une vue de dessus d'un dispositif électronique empilé en cours de fabrication.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

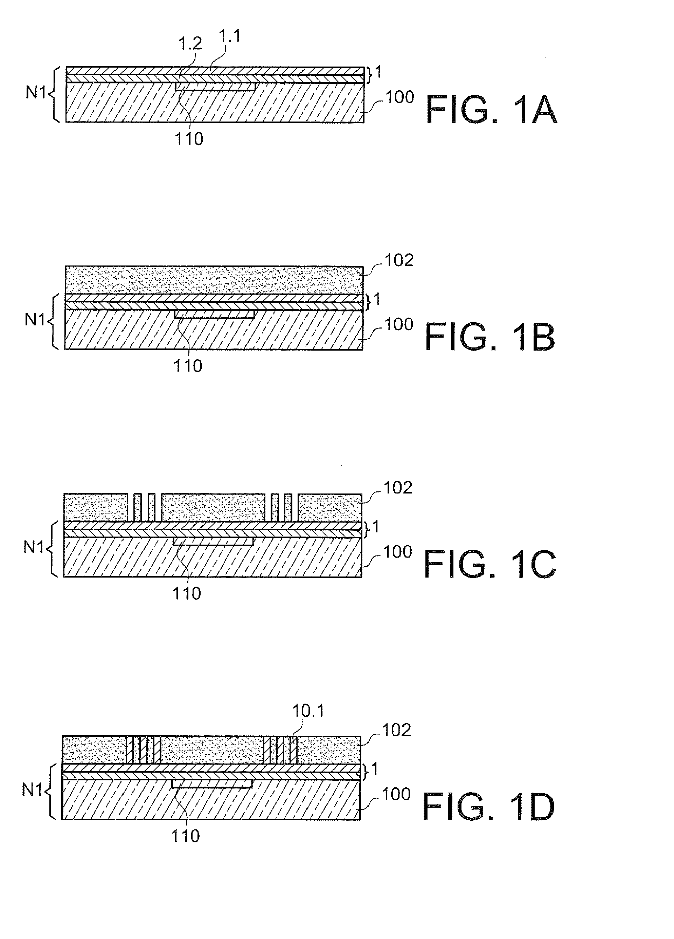

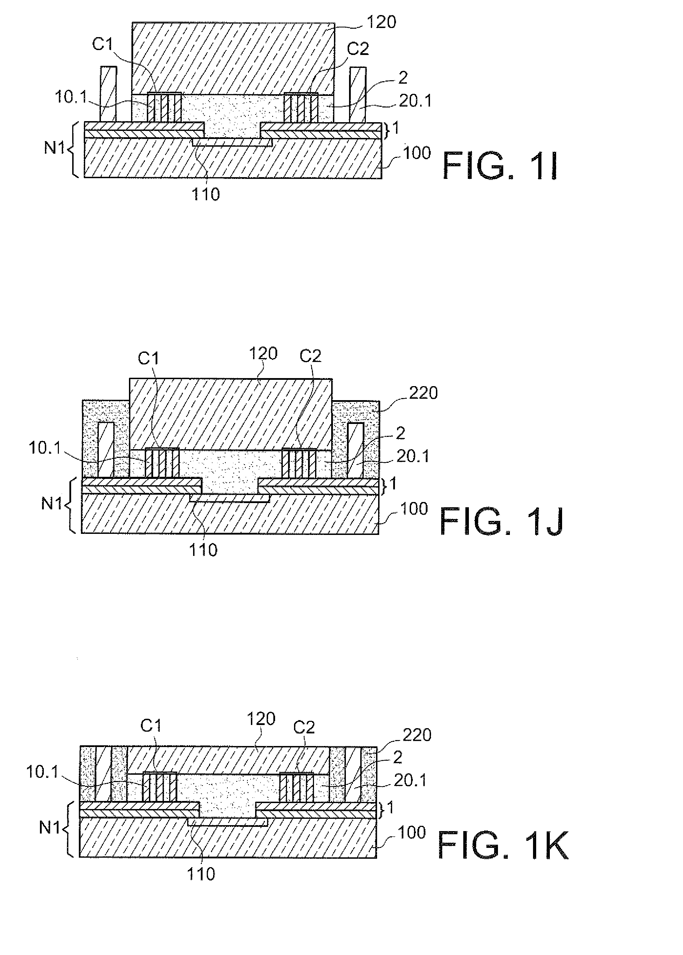

On va maintenant décrire un exemple de procédé de réalisation d'un dispositif électronique empilé objet de l'invention. On part d'un substrat de base 100 incluant ou non un composant électronique. Ce substrat de base 100 contribue à matérialiser un niveau de base N1. On suppose que dans l'exemple décrit, un composant électronique est intégré dans ce substrat 100, il est référencé 110. On dépose en surface de ce substrat de base 100 un fond conducteur 1. Ce fond conducteur 1 peut être formé d'un empilement de deux sous-couches 1.1, 1.2. Il peut s'agir, par exemple, d'une sous-couche 1.1 électriquement conductrice d'épaisseur de l'ordre de 300 nanomètres surmontant une sous-couche d'accroche 1.2. La sous-couche électriquement conductrice 1.1 peut être par exemple à base de cuivre. La sous-couche d'accroche 1.2 peut être par exemple à base de titane. La sous-couche d'accroche 1.2 à base de titane peut avoir une épaisseur de l'ordre de 20 nanomètres. Ce fond conducteur 1 va servir, par exemple, à faire au moins élément de contact, qui peut être relié à un contact du composant électronique 110 intégré dans le substrat 100 ou qui peut recevoir l'alimentation électrique du dispositif électronique empilé. Tout cela est illustré sur la figure 1A.

On va ensuite réaliser un ou plusieurs plots de connexion électrolytiques 10.1 d'un premier type sur le substrat de base 100. Ces plots de connexion sont qualifiés d'électrolytiques car ils sont réalisés par électrolyse comme on le décrit ci-dessous. Ces plots de connexion 10.1 électrolytiques de premier type sont destinés à relier électriquement un élément de contact d'un composant électronique qui sera placé sur un premier niveau rapporté N2 sur le niveau de base pour commencer à former l'empilement, à un élément de contact du niveau voisin sous-jacent, c'est-à-dire du niveau de base N1. Le premier niveau N2 rapporté est voisin du niveau de base N1 et sus-jacent au niveau de base N1. Le dispositif électronique empilé objet de l'invention peut comporter qu'un seul niveau rapporté N2 ou plusieurs empilés les uns sur les autres.

Pour cela on revêt, à la figure 1B, d'une couche de résine 102 le fond conducteur 1 du niveau de base N1. A la figure 1C, on forme dans la couche de résine 102 par lithographie un motif en creux 11 pour chacun des plots de connexion électrolytiques de premier type. Ces motifs en creux 11 sont des trous traversant dans la résine 102 et atteignant le fond conducteur 1. Il est préférable que les plots de connexion électrolytiques 10.1 de premier type soient formés d'un ou plusieurs micro-inserts en forme de picots issus du niveau sous-jacent N1. Les micro-inserts peuvent avoir un diamètre de l'ordre de 1 à 10 micromètres pour une hauteur de l'ordre de 2 à 15 micromètres pour le groupe.

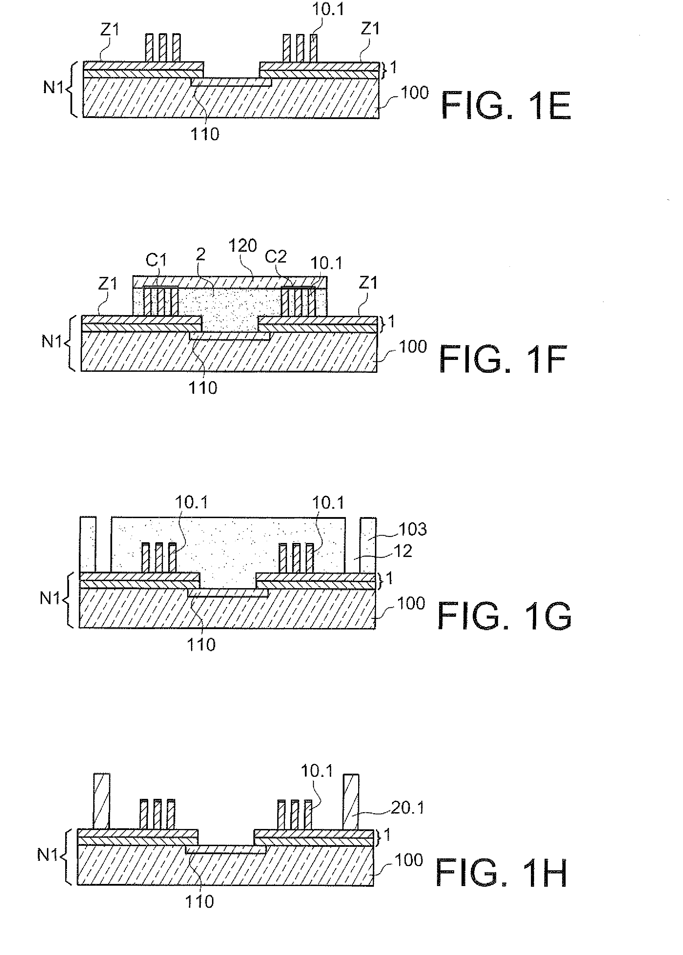

Les motifs en creux 11 dans la résine 102 sont ensuite remplis du matériau du plot de connexion électrolytique 10.1 de premier type, par exemple à base de nickel et/ou de cuivre et/ou d'or, par électrolyse. On se réfère à la figure 1D. On élimine ensuite la couche de résine 102 à la figure 1E. On peut prévoir, à ce stade, une étape de lithographie suivie d'une gravure dans le fond conducteur 1 pour délimiter une ou plusieurs pistes conductrices z1 reliées aux plots de connexion électrolytiques de premier type 10.1 et éventuellement de second type à venir. Cette étape est aussi illustrée à la figure 1E. Cette étape de délimitation du fond conducteur 1 pourrait être réalisée avant la formation des plots de connexion électrolytiques 10.1 de premier type.

A ce stade, il est possible de rapporter au moins un composant électronique 120 contribuant à former le premier niveau rapporté N2 sur les plots de connexion électrolytiques 10.1 de premier type précédemment formés sur le substrat de base 100. Le report s'effectue de préférence à ce stade, si le composant électronique 120 rapporté est mince ou aminci. S'il est épais, c'est-à-dire s'il est plus épais que des plots de connexion de second type réalisés ultérieurement, il est préférable d'effectuer le report après la réalisation de ces plots de connexion de second type. On suppose que sur la figure 1F le report est effectué mais que sur les figures 1G et suivantes il n'est pas réalisé. Si l'on rapporte plusieurs composants électroniques, on les place côte à côte.

Lors du report du composant électronique 120 du premier niveau rapporté N2, on s'arrange pour que ses contacts électriques c1, c2 viennent en contact électrique avec les plots de connexion électrolytiques 10.1 de premier type ainsi créés. Le composant électronique 120 est assemblé au niveau de base N1, à l'aide de colle 2, par exemple, de type polymère BCB (benzocyclobutène) ou époxy. L'assemblage enrobe les plots de connexion électrolytiques de premier type 10.1. Les plots de connexion électrolytiques de premier type 10.1 sont donc surmontés du composant électronique 120.

On se réfère maintenant à la figure 1G qui suit directement la figure 1E, en sautant l'étape de la figure 1F. Sur la figure 1G le composant électronique du premier niveau rapporté N2 n'a pas encore été rapporté.

On va réaliser maintenant un ou plusieurs plots de connexion électrolytiques 20.1 de second type destinés à relier électriquement un niveau donné N1 avec un autre niveau du dispositif électronique empilé objet de l'invention. Les plots de connexion électrolytiques 20.1 de second type pourront être localisés hors de l'emprise que le composant électronique 120 qui vient d'être assemblé (ou qui va être assemblé) sur le niveau voisin sous-jacent possède. En variante les plots de connexion électrolytiques de second type pourraient traverser le composant électronique 120 s'il est prévu pour cela. Dans l'exemple décrit, les plots de connexion électrolytiques 20.1 de second type vont connecter des pistes situées au niveau de base N1 à d'autres pistes conductrices qui se trouvent au dessus du composant électronique 120 du premier niveau rapporté N2. Les plots de connexion électrolytiques 20.1 de second type peuvent avoir un diamètre compris dans une plage allant d'environ 100 à 200 micromètres et une hauteur comprise entre environ 50 et 150 micromètres. Cette hauteur correspond sensiblement à l'épaisseur d'une couche d'un matériau d'enrobage enrobant latéralement le composant électronique 120 du premier niveau rapporté N2. Ils traversent de part en part l'épaisseur de cette couche de matériau d'enrobage comme on le verra ultérieurement. Les plots de connexion électrolytiques 20.1 de second type peuvent affleurer ou dépasser en hauteur le composant électronique 120 du premier niveau rapporté N2.

Les plots de connexion électrolytiques 20.1 de second type sont également réalisés par lithographie et électrolyse. On dépose en surface du substrat de base 100 revêtu du fond conducteur 1 de la résine 103, on délimite dedans des motifs en creux 12 correspondant aux plots de connexion électrolytiques de second type 20.1. Les motifs en creux 12 mettent à nu le fond conducteur 1 (figure 1G). On remplit ces motifs en creux 12, par électrolyse, de métal, par exemple à base de cuivre et/ou de nickel et/ou d'or. On finit par éliminer la résine 103 (figure 1H).

On peut effectuer une délimitation par lithographie et gravure du fond conducteur 1 de manière à délimiter des pistes conductrices z1 notamment associés aux plots de connexion électrolytiques de second type 20.1, ainsi qu'aux plots de connexion électrolytiques 10.1 de premier type si cette étape de gravure n'a pas eu lieu avant la réalisation des plots de connexion électrolytiques 20.1 de second type. Cette étape peut être qualifiée d'étape de reroutage. Cette étape peut se faire par gravure à travers un masque obtenu par lithographie.

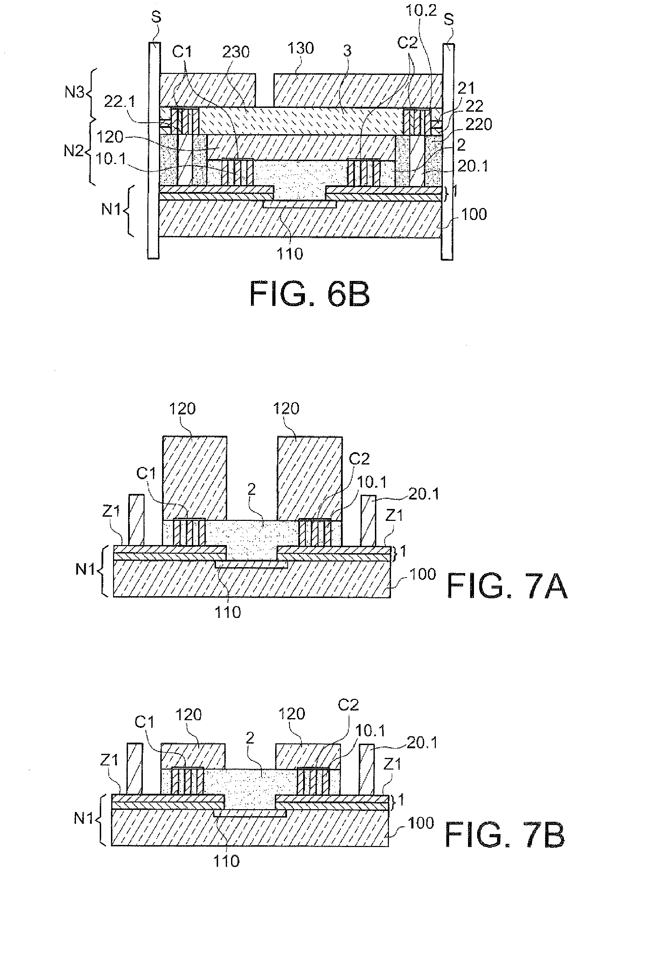

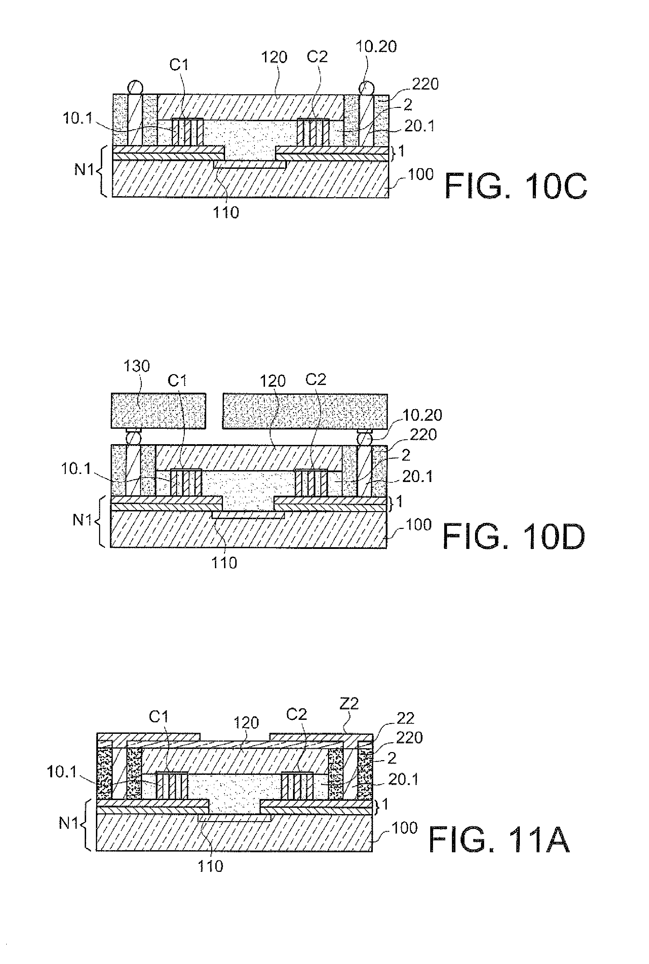

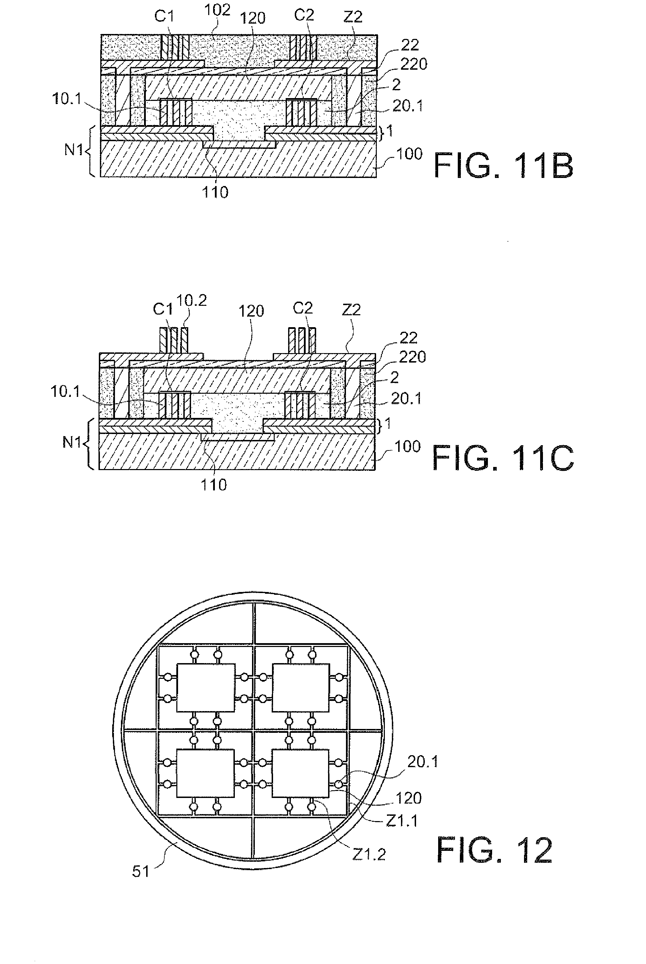

Si le composant 120 du premier niveau rapporté N2 n'a pas encore été rapporté, on le rapporte maintenant (figure 11) et on l'assemble. L'assemblage se fait comme décrit précédemment par collage. Le composant électronique 120 du premier niveau rapporté N2 a une épaisseur plus grande que la hauteur des plots de connexion électrolytiques de second type 20.1. Le sommet des plots de connexion électrolytiques de second type 20.1 n'atteint pas celui du composant électronique 120 du premier niveau rapporté N2. On peut facultativement effectuer une étape de rodage visant à amincir le composant électronique 120 du premier niveau rapporté N2. Cette étape n'est pas illustrée ici, mais elle est illustrée à la figure 7B.

On procède ensuite à un enrobage avec une couche 220, par exemple de résine de type époxy, des plots de connexion électrolytiques de second type 20.1 et du composant électronique 120 du premier niveau rapporté N2. On se réfère à la figure 1J. Cette couche d'enrobage 220 va contribuer à compléter le premier niveau rapporté N2 du dispositif électronique empilé de l'invention, elle enrobe latéralement le composant électronique 120 du premier niveau rapporté N2.

Par une étape de rodage (figure 1K), on réduit la hauteur du composant électronique 120 du premier niveau rapporté N2 et on met à nu le sommet des plots de connexion électrolytiques de second type 20.1. Les plots de connexion électrolytiques de second type 20.1 traversent de part en part l'épaisseur de la couche d'enrobage 220. Le composant électronique 120 du premier niveau rapporté N2 peut avoir une hauteur, après l'étape de rodage, comprise par exemple entre environ 40 et 60 micromètres. On peut s'arrêter là s'il n'y a qu'un seul niveau rapporté N2. S'il y en a plusieurs, on peut continuer en enchaînant les étapes suivantes.

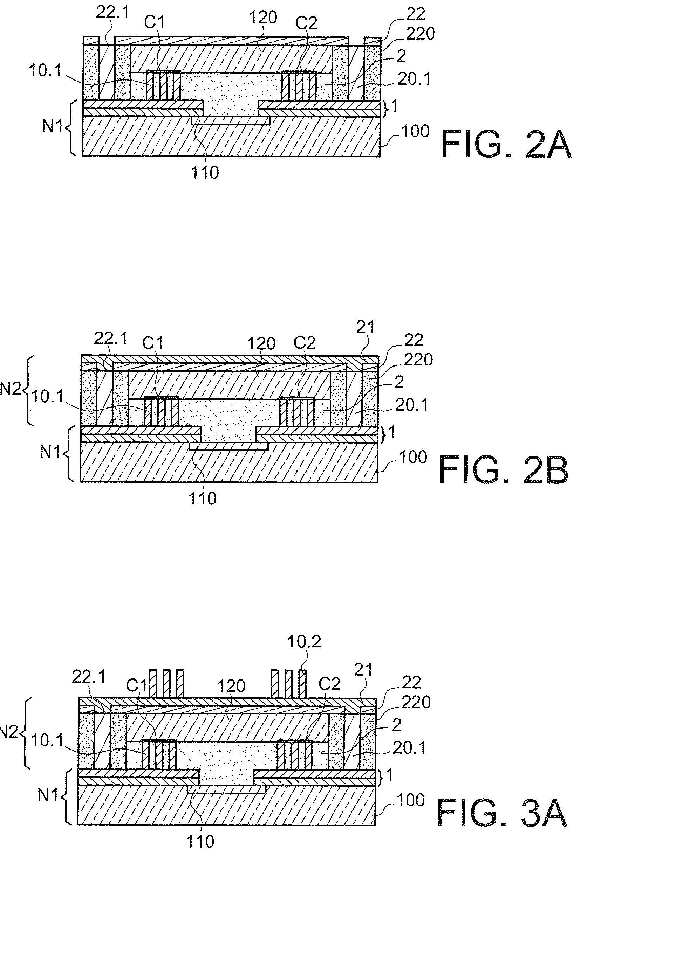

Ultérieurement, comme illustré à la figure 2A, on peut former ensuite une couche diélectrique 22 qui s'étend sur toute la surface rodée et la graver localement pour faire apparaître les plots de connexion de second type 20.1. Au moins une ouverture est obtenue par la gravure, elle est référencée 22.1. La gravure peut se faire à travers un masque obtenu par lithographie. La couche diélectrique 22 peut avoir une épaisseur comprise entre environ 0,2 et 20 micromètres. Cette couche diélectrique 22 peut être organique, par exemple en BCB (benzocyclobutène) ou en résine époxy, ou minérale par exemple en nitrure de silicium SiN ou en oxyde de silicium SiO₂.

Pour terminer le premier niveau rapporté N2 sur le niveau de base N1, on revêt la structure de la figure 2A, d'un fond conducteur 21 comme il a été montré précédemment à la figure 1A. On se réfère à la figure 2B.

Le fond conducteur peut être multicouche avec en premier la sous-couche d'accroche.

On procède ensuite à la réalisation du second niveau rapporté N3.

On commence par réaliser plusieurs plots de connexion électrolytiques de premier type 10.2 comme on l'a décrit aux figures 1B-1E (figure 3A) sur le premier niveau rapporté N2.

Chacun de ces plots de connexion électrolytiques de premier type 10.2 du second niveau rapporté est relié électriquement à un plot de connexion électrolytique de second type 20.1 du premier niveau rapporté N2. La croissance électrolytique a lieu à partir d'un fond conducteur 21, le fond conducteur servant d'électrode pour la croissance électrolytique. C'est d'ailleurs grâce au fond conducteur 21 que le contact électrique se fait entre chaque plot de connexion électrolytique de premier type 10.2 et un plot de connexion électrolytique de second type 20.1 du premier niveau rapporté N2.

Par rapport à une autre configuration dans laquelle seulement quelques plots de connexion électrolytiques de premier type 10.2 du second niveau rapporté N3 seraient reliés électriquement à un plot de connexion électrolytique de second type 20.1 du premier niveau rapporté N2 mais pas à d'autres, l'invention permet d'assurer une continuité électrique entre les plots de connexion électrolytique de premier type et ceux de second type. Cette configuration permet en particulier de réaliser directement une électrolyse des plots de connexion de premier type et de second type à partir du même fond conducteur continu 21, ce qui permet notamment de réduire les coûts. Bien entendu, cette électrolyse peut également être réalisée pour les plots du niveau rapporté à partir de l'élément conducteur z2 notamment pour éviter de découvrir la couche 1 qui pourrait être recouverte par les dépôts successifs.

En variante, comme on le verra ultérieurement un plot peut être directement relié à un plot de connexion électrolytique de second type du niveau sous-jacent.

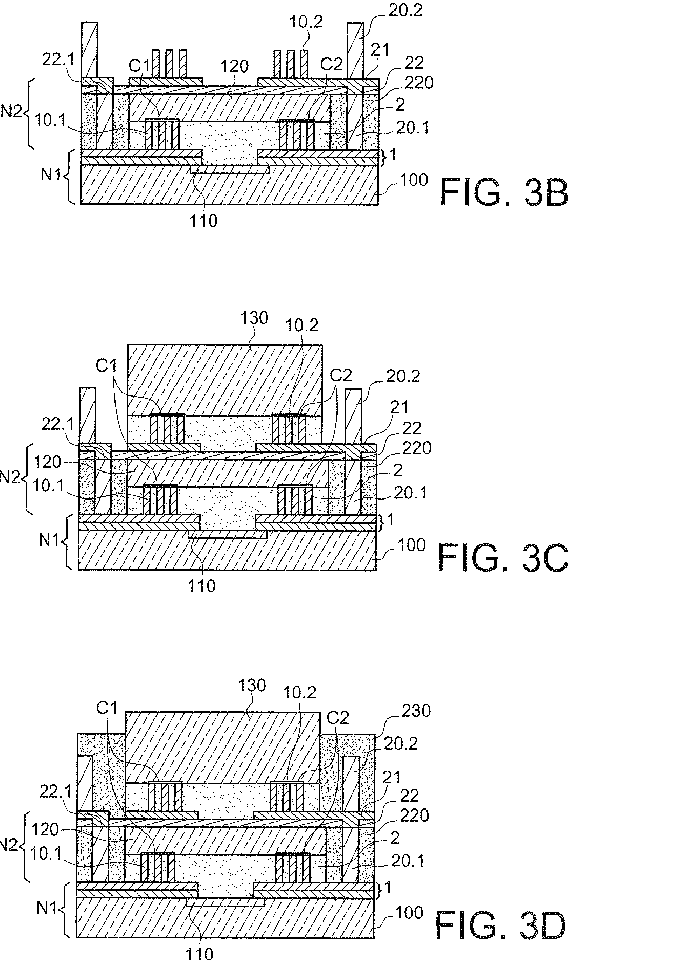

On réalise, à la figure 3B, un ou plusieurs plots de connexion électrolytiques de second type 20.2 comme on l'a décrit aux figures 1G et 1H.

On réalise une étape de gravure du fond conducteur 21 pour délimiter des pistes conductrices z2 reliées électriquement aux plots de connexion électrolytiques de premier type 10.2 et/ou aux plots de connexion de second type 20.2. Un plot de connexion électrolytique 20.2 de second type d'un niveau, par exemple le second niveau rapporté N3, peut être relié par une piste conductrice z2 à un plot conducteur électrolytique de premier type 10.2 du même niveau N3 que lui ou d'un autre niveau que le sien ou bien à un plot de connexion électrolytique de second type d'un autre niveau que le sien. L'étape de gravure peut être réalisée en deux fois, l'une après la réalisation des plots de connexion électrolytiques de premier type 10.2 et l'autre après la réalisation des plots de connexion électrolytiques de second type 20.2. On aurait pu envisager que l'étape de délimitation du fond conducteur 21 ait lieu avant la réalisation des plots de connexion électrolytiques de premier type 10.2 du second niveau rapporté N3.

On rapporte à la figure 3C un ou plusieurs composants électroniques 130 du deuxième niveau rapporté N3 sur les plots de connexion électrolytiques de premier type 10.2 qui viennent d'être réalisés. Cette étape aurait bien sûr pu avoir lieu avant que les plots de connexion électrolytiques de second type 20.2 ne soient réalisés. La colle servant à l'assemblage du composant électronique est référencée 3.

On peut procéder à ce stade, à une étape de rodage du composant électronique 130 du deuxième niveau rapporté N3, mais cette étape est facultative.

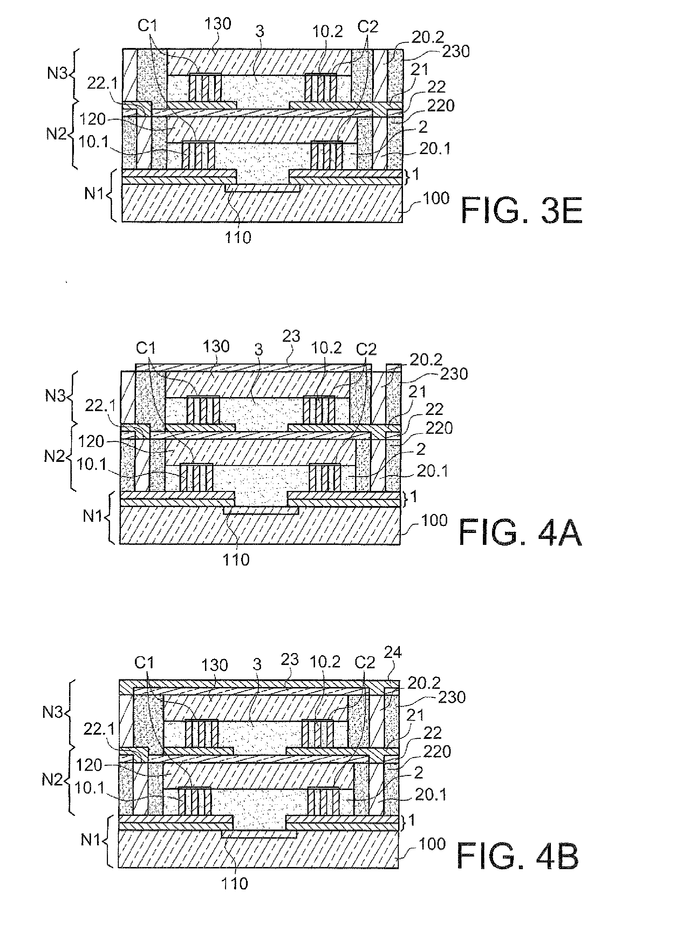

On procède, à la figure 3D, à un enrobage des plots de connexion électrolytiques 20.2 de second type et du composant électronique 130 qui vient d'être rapporté, cet enrobage peut être fait avec de la résine époxy, la couche d'enrobage est référencée 230. Par une étape de rodage, illustrée à la figure 3E, on ajuste la hauteur du deuxième niveau rapporté N3 en s'arrangeant pour mettre à nu le sommet des plots de connexion électrolytiques 20.2 de second type. Si le dispositif électronique empilé objet de l'invention ne comporte pas d'autre niveau, le procédé s'arrête là, le deuxième niveau rapporté N3 étant terminé. Les plots de connexion électrolytiques 20.2 de second type accessibles peuvent servir de contacts par exemple devant être reliés à une source d'énergie ou à un autre dispositif électronique.

Si le dispositif électronique empilé objet de l'invention comporte au moins un troisième niveau rapporté N4 superposé sur le deuxième niveau rapporté N, on peut former une couche diélectrique 23 qui s'étend sur toute la surface rodée. On prévoit localement des ouvertures par gravure pour faire apparaître le sommet des plots de connexion électrolytiques de second type 20.2 (figure 4A). La gravure peut se faire à travers un masque obtenu par lithographie.

Pour terminer le deuxième niveau rapporté N3 (figure 4B), on dépose un fond conducteur 21 comme il a été montré précédemment à la figure 2B.

On procède ensuite à la réalisation d'un troisième niveau rapporté N4.

Ces étapes des figures 4A, 4B sont facultatives notamment si les plots de connexion électrolytiques de premier type que l'on s'apprête à former sont implantés directement sur les plots de connexion électrolytiques de second type du second niveau rapporté N3.

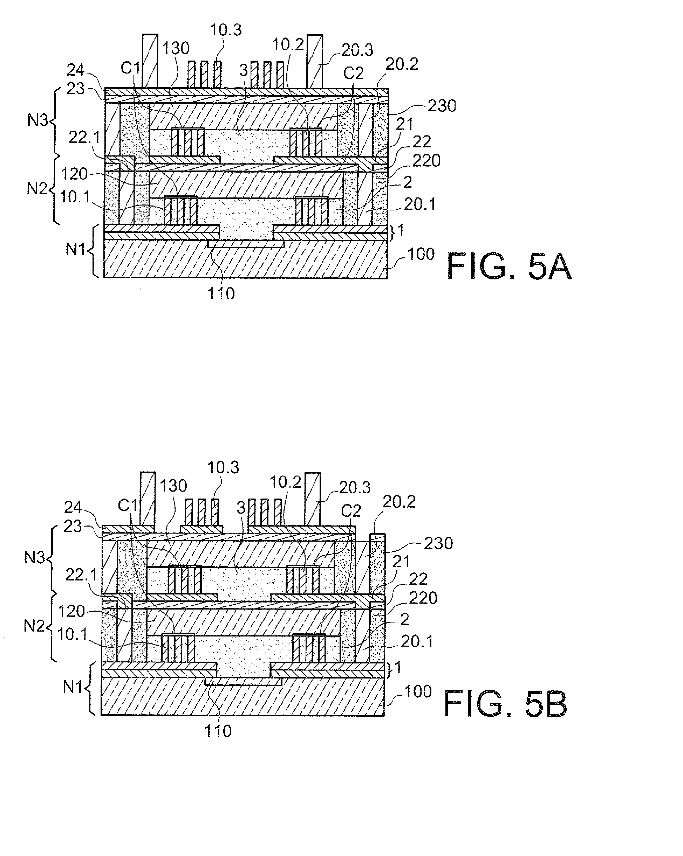

Comme précédemment on réalise un ou plusieurs plots de connexion électrolytiques de premier type 10.3 et un ou plusieurs plots de connexion électrolytiques 20.3 de second type (figure 5A). A la figure 5B, on grave le fond conducteur 21 de manière à délimiter des pistes conductrices z3 venant en contact avec les plots de connexions électrolytiques 10.3 de premier type et/ou les plots de connexion électrolytiques de second type 20.3. On réalise ainsi une étape de reroutage.

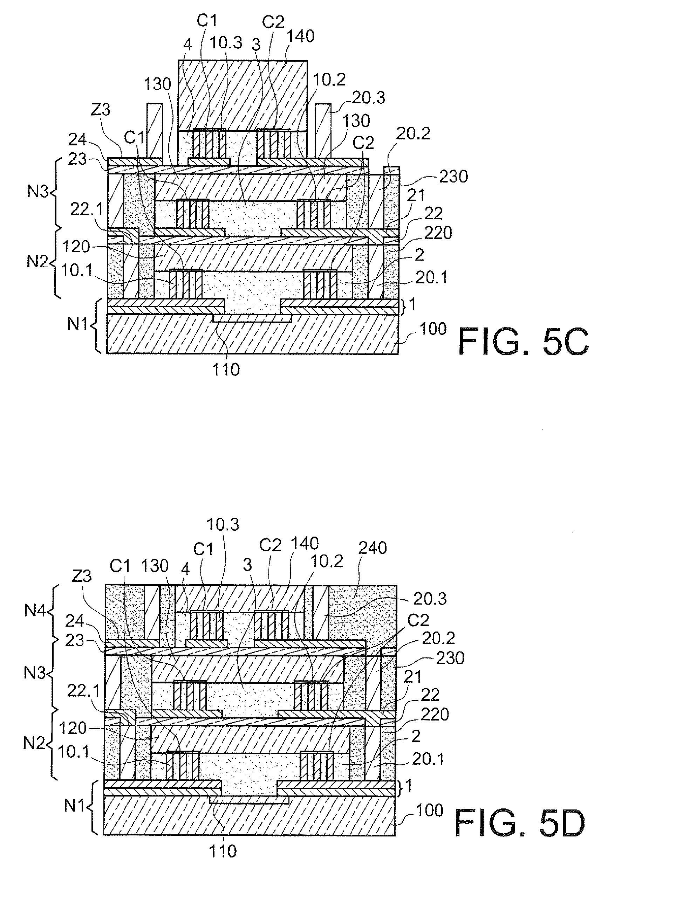

Dans l'exemple décrit, on rapporte, à la figure 5C, après la réalisation des plots de connexion électrolytiques de second type 20.3 et le reroutage, au moins un composant électronique 140 du troisième niveau rapporté N4 sur les plots de connexion électrolytiques 10.3 de premier type et on les assemble par collage. On procède comme à la figure 1F. Si le composant électronique 140 a une épaisseur plus grande que la hauteur des plots de connexion électrolytiques de second type 20.3, on peut procéder tout de suite à une étape de rodage visant à l'amincir. Ici encore le composant électronique 140 du troisième niveau rapporté N4 auraient pu être rapporté au préalable, avant la réalisation des plots de connexion électrolytiques 20.3 de second type.

On procède ensuite à un enrobage avec de la résine, par exemple de type époxy, des plots de connexion électrolytiques de second type 20.3 et du composant électronique 140 du troisième niveau rapporté N4 comme illustré à la figure 5D. La couche d'enrobage est référencée 240. Cette couche d'enrobage 240 va contribuer à compléter le troisième niveau N4 rapporté du dispositif électronique empilé de l'invention. Elle enrobe latéralement le composant électronique 140.

Par une étape de rodage, également illustrée à la figure 5D, on met à nu le sommet des plots de connexion électrolytiques de second type 20.3. Cette étape de rodage peut aussi contribuer à amincir le composant électronique 140 du troisième niveau rapporté N4. Les plots de connexion électrolytiques 20.3 de second type traversent de part en part la couche d'enrobage 240.

A l'issue de cette étape, le dispositif électronique empilé de l'invention peut être terminé. On peut bien sûr envisager de rapporter un ou plusieurs autres niveaux et on procédera pour chaque niveau supplémentaire comme il a été décrit précédemment pour le deuxième niveau rapporté ou le troisième ou selon la description qui suit et qui présente des variantes dans la façon de procéder.

Un niveau du dispositif électronique de l'invention qui vient d'être décrit, éloigné du niveau de base peut ainsi être relié électriquement au niveau de base N1 dans la mesure où deux plots de connexion électrolytiques de second type 20.1, 20.2 de niveaux voisins différents sont situés dans le prolongement l'un de l'autre comme illustré sur les figures 3B à 4B.

Dans la mesure où sur un même substrat de base 100, on a réalisé collectivement plusieurs dispositifs électroniques empilés élémentaires devant être individualisés, on découpe totalement ou partiellement l'empilement obtenu à la scie S pour les séparer. Les traits de scie S peuvent avoir pour fonction de déconnecter des plots de connexion électrolytiques de premier type ou de second type connectés entre eux auparavant par des pistes conductrices z1, z2,... sans pour autant conduire finalement à des morceaux détachés totalement les uns des autres. Cela permet d'isoler électriquement des composants électroniques entre eux notamment lorsque les croissances électrolytiques sont réalisées à partir des mêmes couches conductrices.

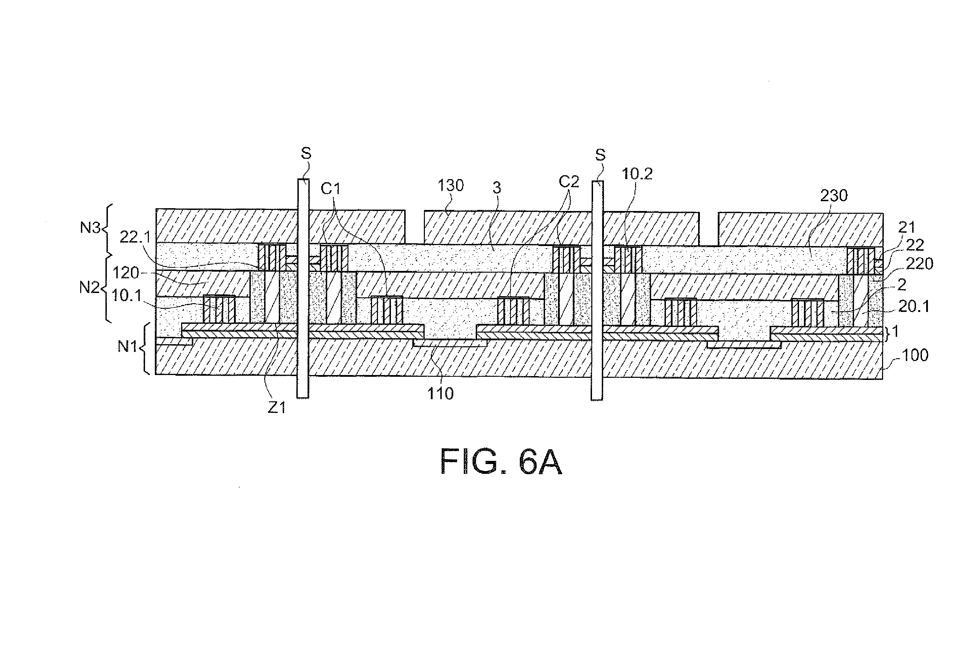

Aux figures 6A, 6B l'empilement ne comporte que deux niveaux rapportés N2, N3. Sur les figures 6, on voit bien la coupure de la piste conductrice référencée z2 entre les deux plots de connexion électrolytiques de second type 20.1. Le trait de scie S a scindé en deux un composant électronique rapporté, comme illustré sur la figure 6A avec le composant électronique 120. On obtient alors une pluralité de dispositifs électroniques empilés individuels, l'un d'entre eux est montré sur la figure 6B.

Il est bien sûr possible de rapporter deux composants électroniques 120 voisins par niveaux comme illustré sur la figure 6A. Les deux composants électroniques 130 sont placés côte à côte sur le même niveau.

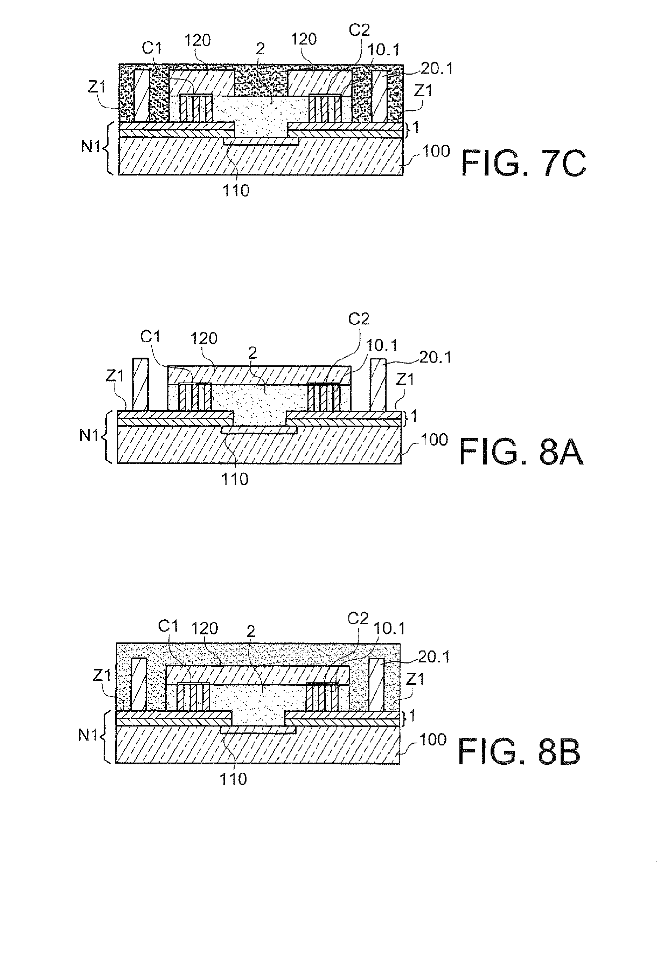

Si au moins un composant électronique 120 d'un niveau est particulièrement épais comme sur la figure 7A, une étape de rodage (figure 7B) du composant électronique 120 pour l'amincir peut avoir lieu avant l'étape d'enrobage (figure 7C). L'épaisseur du composant électronique 120 peut rester supérieure à la hauteur des plots de connexion électrolytiques 20.1 de second type avant l'enrobage.

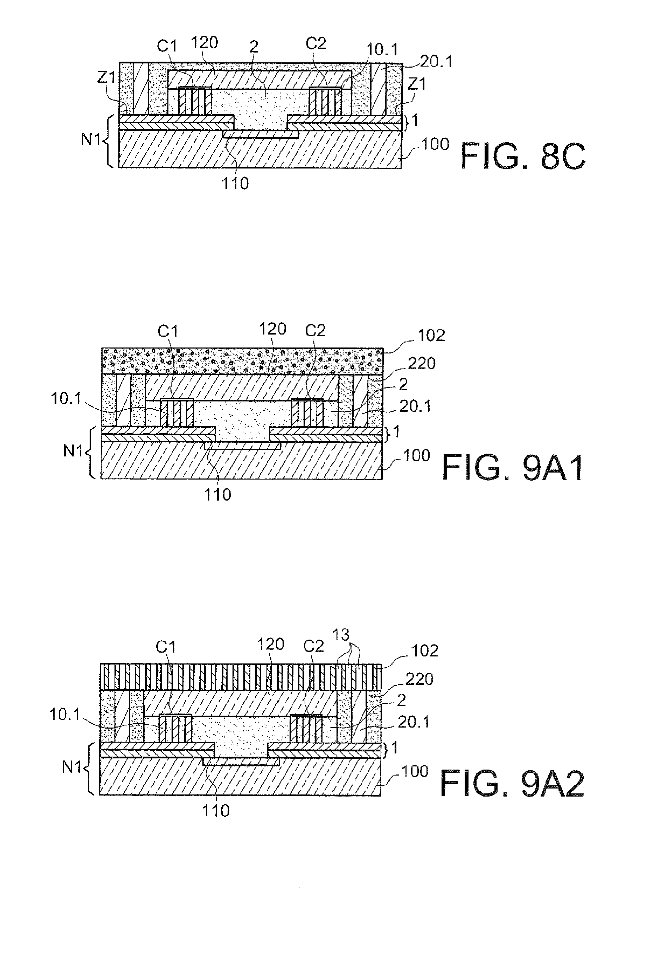

En variante illustrée sur la figure 8A, l'épaisseur du composant électronique 120 est inférieure à la hauteur des plots de connexion électrolytiques de second type 20.1. Il n'y a donc pas d'étape de rodage préalable à l'étape d'enrobage (figure 8B). L'étape de rodage (figure 8C) qui suit l'étape d'enrobage n'attaque pas le composant électronique 120.

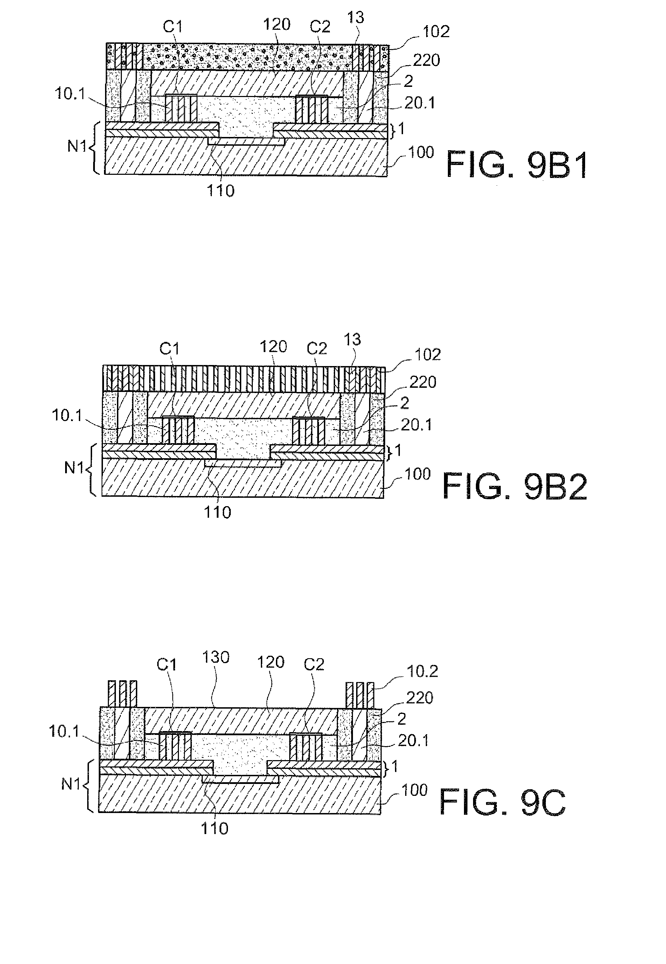

Selon une autre variante, il est possible qu'un ou plusieurs plots de connexion électrolytiques de premier type 10.2, implantés sur un niveau rapporté N2, soient réalisés directement sur des plots de connexion électrolytiques de second type 20.1 dudit niveau rapporté N2. Ils sont situés directement dans le prolongement des plots de connexion électrolytiques de second type 20.1 comme illustré sur les figures 9B1, 9B2, 9C et 9D. Dans cette configuration, on ne réalise donc pas ni de couche diélectrique, ni de fond conducteur à la suite de l'étape de rodage comme on l'avait décrit aux figures 2A et 2B. On fait simplement croître par électrolyse les plots de connexion électrolytiques de premier type 10.2 d'un niveau donné directement sur les plots de connexion électrolytiques de second type 20.1 du niveau sous-jacent. Les plots de connexion électrolytiques de second type 20.1 du niveau sous-jacent servent d'électrode pour la croissance électrolytique.

A la suite de l'étape de rodage qui met à nu les plots de connexion électrolytiques 20.1 du premier niveau rapporté N2 illustrée à la figure 1K, on revêt la structure rodée de résine 102 (figure 9A1). A la figure 9B1, on forme dans la couche de résine 102, par lithographie, un motif en creux 13 pour chacun des plots de connexion électrolytiques de premier type 10.2 à réaliser. Les motifs en creux 13 dans la résine 102, mettent à nu le sommet des plots de connexion électrolytiques de second type 20.1. Ils sont ensuite remplis du matériau du plot de connexion électrolytique 10.2, par exemple à base de nickel et/ou de cuivre et/ou d'or, par électrolyse. On se réfère à la figure 9B1. Les plots de connexion électrolytique de premier type 10.2 ne sont pas forcément dans le même matériau que les plots de connexion électrolytique 20.1 qu'ils surmontent.

En variante illustrée aux figures 9A2 et 9B2, il est possible de réaliser une pluralité de motifs en creux 13 répartis sur toute la surface de la couche de résine 102 (figure 9A2). Les motifs en creux 13 qui se trouvent au dessus des plots de connexion électrolytique de second type 20.1 les exposent. On évite ainsi des problèmes d'alignement. Lors du remplissage par électrolyse, seuls les motifs se trouvant au dessus des plots de connexion électrolytique de second type 20.1 se rempliront car les motifs en creux débouchent sur une surface conductrice de l'électricité et polarisée.

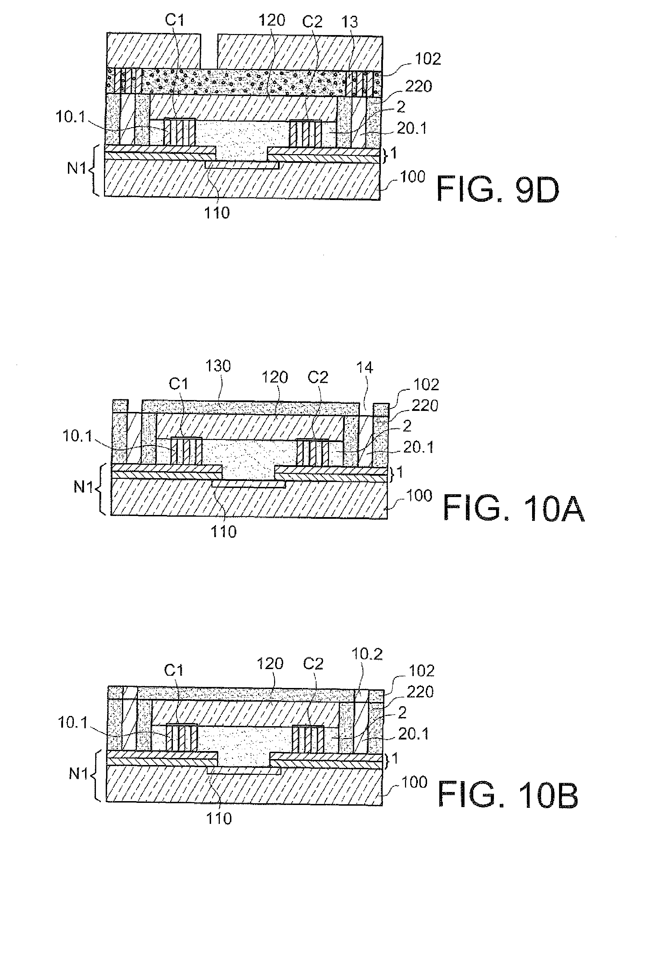

On élimine ensuite la couche de résine 102 à la figure 9C. On peut ensuite rapporter et assembler un ou plusieurs composants électroniques 130 du second niveau rapporté N3 (figure 9D). On place les éléments de contact des composants électroniques rapportés 130 de manière à ce qu'ils viennent en contact électrique avec les plots de connexion électrolytiques de premier type 10.2 ainsi créés.

Sur les figures 9, les plots de connexion électrolytiques de premier type 10.2 du second niveau rapporté sont toujours des micro-inserts. Il est bien sûr possible que les plots de connexion électrolytiques de premier type soient des billes fusibles si la température n'est pas une contrainte. On se réfère aux figures 10A à 10D. Cette série de figures est spécifique à une configuration proche de celle décrite précédemment dans laquelle les plots de connexion électrolytiques de premier type, implantés sur niveau rapporté, sont dans le prolongement direct des plots de connexion électrolytiques de second type du dit niveau rapporté. Il est bien sûr possible que les billes fusibles soient décalées par rapport au sommet des plots de connexion électrolytiques de second type d'un niveau rapporté sous jacent comme décrit précédemment aux figures 11, mais chacune d'entre elle est reliée électriquement à un plot de connexion électrolytique de second type du niveau sous-jacent.

On se réfère aux figures 10. Dans cette configuration, après l'étape de rodage, on ne dépose pas non plus de fond conducteur puisque les plots de connexion électrolytiques de premier type 10.2 vont être dans le prolongement des plots de connexion électrolytiques de second type 20.1 du niveau sous-jacent.

A la suite de l'étape de rodage qui met à nu les plots de connexion électrolytiques 20.1 de second type du premier niveau rapporté N2, illustrée à la figure 1K, on revêt la structure rodée de résine 102 (figure 10A). L'épaisseur de résine est comprise entre environ 20 et 100 micromètres. A la figure 10A, on forme également dans la couche de résine 102, par lithographie, un motif en creux 14 pour des plots de connexion électrolytiques devant se transformer ensuite en billes fusibles. Les motifs en creux 14 dans la résine 102 sont ensuite remplis du matériau conducteur fusible des billes fusibles, par exemple l'indium In, ou un alliage à base d'étain et de plomb SnPb, d'étain, d'argent et de cuivre SnAgCu, de plomb, d'argent et de cuivre PbAgCu. On entend par matériau conducteur fusible dans le domaine de l'électronique, un matériau conducteur apte à fondre une température suffisamment basse pour éviter la dégradation de composants qui vont être assemblés avec ce matériau. Un homme du métier spécialiste d'électronique sait parfaitement ce qu'est un matériau conducteur fusible. On se réfère à la figure 10B. On élimine ensuite la couche de résine 102 à la figure 10C et on forme les billes fusibles 10.20 par refusion.

On peut ensuite rapporter par soudure grâce aux billes fusibles 10.20 un ou plusieurs composants électroniques 130 du second niveau rapporté N3 sur le premier niveau rapporté N2 (figure 10D). On place les éléments de contact 50 des composants électroniques 130 rapportés de manière à ce qu'ils viennent en contact électrique avec les billes fusibles type 10.20 ainsi créées.

Encore une autre variante va être décrite ci-après aux figures 11, elle concerne la fabrication des plots de connexion électrolytiques de premier type formés sur un niveau rapporté. Chacun de ces plots de connexion électrolytiques de premier type va être relié électriquement à un plot de connexion électrolytique de second type du niveau 20.1 sur lequel il est implanté. Les plots de connexion électrolytiques de premier type vont être décalés par rapport aux plots de connexion électrolytiques de second type 20.1. Comme décrit aux figures 2A, 2B, 3A, après l'étape de rodage, on dépose une couche diélectrique 22 sur la structure rodée, on grave des ouvertures 14 au niveau du sommet des plots de connexion électrolytiques de second type 20.1 pour les mettre à nu, on forme le fond conducteur 21 sur la structure rodée revêtue partiellement de la couche diélectrique 22, on le modèle pour réaliser des pistes conductrices z2 qui forment un reroutage vers les plots de connexion électrolytiques de premier type à venir (figure 11A).

Enfin on réalise lesdits plots de connexion électrolytiques de premier type 10.2 par lithographie et électrolyse comme décrit plus haut (figures 11B et 11C). Par rapport à la description des figures 2 et 3, on réalise le modelage du fond conducteur 21 avant de réaliser les plots de connexion électrolytiques de premier type 10.2.

La figure 12 illustre en vue de dessus un dispositif électronique empilé de l'invention en cours de fabrication. Le support de base 100 en forme de disque comporte un anneau périphérique conducteur 51.On voit les composants électroniques 120 du premier niveau rapporté N2. Les tronçons z1.2 sont des tronçons de pistes conductrices z1 reliant des composants électroniques 120 via des plots de connexion électrolytiques de premier type (non visibles car cachés sous les composants 120) à des plots de connexion électrolytiques de second type 20.1. Les tronçons z1.1 sont des tronçons de pistes conductrices z1 reliant des plots de connexion électrolytiques de second type 20.1 l'anneau périphérique 51.

Bien que plusieurs modes de réalisation de la présente invention aient été représentés et décrits de façon détaillée, on comprendra que différents changements et modifications puissent être apportés sans sortir du cadre de l'invention. Notamment certaines étapes du procédé peuvent avoir lieu dans un ordre différent.

En outre, les différentes variantes décrites doivent être comprises comme n'étant pas forcément exclusives les unes des autres.

## Revendications

1. Procédé de réalisation d'un dispositif électronique empilé comportant des composants électroniques (120, 130) répartis sur au moins un niveau rapporté (N2, N3) sur un niveau de base (N1) accueillant éventuellement au moins un composant électronique, de manière à former plusieurs dispositifs électroniques élémentaires, dans lequel:
a°) on forme un fond conducteur (1) en surface du niveau de base (N1);
b°) on réalise par électrolyse sur le fond conducteur des plots de connexion électrolytiques de premier type (10.1), les plots de connexion électrolytiques de premier type (10.1) étant en contact électrique direct avec un premier élément conducteur (z1) du niveau de base (N1);
c°) on rapporte un ou plusieurs composants électroniques (120) du niveau rapporté (N2) dit premier niveau rapporté, sur le niveau de base (N1) et on les assemble de manière à ce qu'un élément conducteur (c1, c2) porté par une face d'un composant électronique soit en contact électrique direct avec un plot de connexion électrolytique de premier type (10.1) réalisé à l'étape b°);
d°) on réalise par électrolyse sur le fond conducteur (1) des plots de connexion électrolytiques de second type (20.1), les plots de connexion électrolytiques de second type (20.1) étant en contact électrique direct avec un second élément conducteur du niveau de base (N1), ces plots de connexion électrolytiques de second type (20.1) affleurant ou dépassant les composants électroniques (120) du premier niveau rapporté (N2) ;
e°) on enrobe les plots de connexion électrolytiques de second type (20.1) réalisés à l'étape d°) et les composants électroniques (120) du premier niveau rapporté (N2) d'un matériau d'enrobage (220), le sommet des plots de connexion électrolytiques de second type (20.1) étant à nu, les étapes b°) à e°) ne contribuant à réaliser que le premier niveau rapporté (N2) ;
f°) on réalise par électrolyse sur le premier niveau rapporté (N2) des plots de connexion électrolytiques de premier type (10.2), chaque plot de connexion électrolytique de premier type (10.2) étant en contact électrique avec un plot de connexion électrolytique de second type (20.1) réalisé à l'étape d°) ;
g°) on effectue une découpe partielle ou totale du dispositif électronique empilé pour former et séparer électriquement les dispositifs électroniques élémentaires.

2. Procédé de réalisation d'un dispositif électronique empilé selon la revendication 1 dans lequel les composants électroniques (120) sont placés côte à côte sur le même niveau.

3. Procédé de réalisation d'un dispositif électronique empilé selon l'une des revendications 1 ou 2, dans lequel un plot de connexion électrolytique de premier type réalisé sur le premier niveau rapporté (N2) est en contact électrique direct avec un premier élément conducteur (z2) du premier niveau rapporté, le contact électrique avec le plot de connexion électrolytique de second type se faisant par ce premier élément conducteur.

4. Procédé de réalisation d'un dispositif électronique empilé selon la revendication 3, dans lequel entre l'étape f°) et l'étape g°):
h°) on rapporte un ou plusieurs composants électroniques (130) du second niveau rapporté (N3) sur le premier niveau rapporté (N2) et on les assemble de manière à ce qu'un élément conducteur (c1, c2) porté par une face d'un composant électronique (130) soit en contact électrique direct avec un plot de connexion électrolytique de premier type (10.2) réalisé à l'étape f°) ;
i°) on réalise par électrolyse sur le premier niveau rapporté (N2) des plots de connexion électrolytiques de second type (20.2), les plots de connexion électrolytiques de second type (20.2) étant en contact électrique direct avec un second élément conducteur (z2) du premier niveau rapporté (N2), ces plots de connexion électrolytiques de second type (20.2) affleurant ou dépassant les composants électroniques (130) du second niveau rapporté (N3) ;
j°) on enrobe les plots de connexion électrolytiques de second type (20.2) réalisés à l'étape i°) et les composants électroniques (130) du second niveau rapporté (N3) d'un matériau d'enrobage (230), le sommet des plots de connexion électrolytiques de second type (20.2) étant à nu, ces étapes contribuant à réaliser le second niveau rapporté (N3).

5. Procédé de réalisation d'un dispositif électronique empilé selon la revendication 4, dans lequel avant l'étape g°) on réitère les étapes f°) et h°) à j°) au moins une nième fois (n supérieur ou égal à deux) de manière à obtenir un nième+1 niveau rapporté, le premier niveau rapporté devenant le nième-1 niveau rapporté, le second niveau rapporté devenant le nième niveau rapporté, le niveau de base devenant le nième-2 niveau.

6. Procédé de réalisation d'un dispositif électronique empilé selon l'une des revendications 1 à 5, dans lequel un plot de connexion électrolytique de second type (20.1) est situé hors de l'emprise que le composant électronique (120) d'un niveau rapporté (N2, N3) possède sur le niveau sous-jacent (N1, N2) sur lequel est réalisé le plot de connexion électrolytique de second type.

7. Procédé de réalisation d'un dispositif électronique empilé selon l'une des revendications 1 ou 4, dans lequel aux étapes e°) ou j°) la mise à nu du sommet des plots de connexion électrolytiques de second type (20.1) et des plots de connexion électrolytiques de second type (20.2) est obtenue par rodage au moins du matériau d'enrobage (220, 230) et éventuellement des composants électroniques (120, 130) du premier niveau rapporté (N2) et/ou du second niveau rapporté (N3) de manière à les amincir.

8. Procédé de réalisation d'un dispositif électronique empilé selon l'une des revendications 1 à 7, dans lequel on réalise le premier élément conducteur (z1) et/ou le second élément conducteur (z1) du niveau de base (N1) en gravant le fond conducteur (1) formé en surface du niveau de base (N1).

9. Procédé de réalisation d'un dispositif électronique empilé selon l'une des revendications 3 à 8, dans lequel après l'étape j°) mais avant l'étape g°) on forme une couche diélectrique en surface et on l'ouvre pour faire apparaître le sommet des plots de connexion électrolytiques de second type 20.1) réalisés à l'étape i°), puis on la revêt d'un fond conducteur (21), on réalise le premier élément conducteur (z2) et/ou le second élément conducteur (z2) du premier niveau rapporté (N2) en gravant ledit fond conducteur (21).

10. Procédé de réalisation d'un dispositif électronique empilé selon l'une des revendications 1 à 9, dans lequel le premier élément conducteur (z1) et le second élément conducteur (z1) du niveau de base (N1) sont confondus et/ou le premier élément conducteur (z2) et le second élément conducteur (z2) du premier niveau rapporté (N2) sont confondus.

11. Procédé de réalisation d'un dispositif électronique empilé selon l'une des revendications 1 à 10, dans lequel on fait croître par électrolyse les plots de connexion électrolytiques de premier type (10.2) réalisés à l'étape f°) directement sur le sommet des plots de connexion électrolytiques de second type (20.1) réalisés à l'étape d°).

12. Procédé de réalisation d'un composant électronique empilé selon l'une des revendications 7 à 11, dans lequel l'étape c°) est réalisée avant l'étape d°) et/ou l'étape h°) est réalisée avant l'étape i°), on prévoit une étape d'amincissement des composants électroniques (120, 130) avant l'étape d°) et/ou l'étape h°).

13. Procédé de réalisation d'un dispositif électronique empilé selon la revendication 1, dans lequel la découpe comporte une découpe d'au moins un élément conducteur (z1) du niveau de base (N1) visant à isoler électriquement les dispositifs électroniques élémentaires.

14. Procédé de réalisation d'un dispositif électronique empilé selon l'une des revendications 1 à 13, dans lequel un plot de connexion électrolytique de premier type (10.1) prend la forme d'un micro-insert, d'un ensemble de micro-inserts ou d'une bille fusible.

15. Procédé de réalisation d'un dispositif électronique empilé selon l'une des revendications 1 à 14, dans lequel lorsque les plots de connexion électrolytiques de premier type (10.2) sont des billes fusibles, on procède à une étape de refusion entre l'étape f°) et l'étape h°) mais avant l'étape g°) pour que les plots de connexion électrolytiques de premier type (10.2) réalisés à l'étape f°) se transforment en billes fusibles.

16. Procédé de réalisation d'un dispositif électronique empilé selon l'une des revendications 1 à 15, dans lequel un plot de connexion électrolytique de premier type (10.1) a une hauteur inférieure à celle d'un plot de connexion électrolytique de second type (20.1).
